# EUROPEAN PATENT APPLICATION

(11) **EP 4 761 109 A1**
(43) Date of publication of application: **17.06.2026**
(21) Application number: 25192746.3
(22) Date of filing: 30.07.2025
(51) Int. Cl.: H03F 3/72, H03F 1/52, H03F 3/24, H03F 1/02

(54) **POWER AMPLIFIER AND CIRCUIT PROTECTION METHOD**

(30) Priority: 13.12.2024 TW 113148623
(71) Applicant: RichWave Technology Corp., Taipei City 114 (TW)
(72) Inventor: Wang, Yi-Fong, 114 Taipei City (TW)
(74) Representative: Straus, Alexander

(57) **Abstract**

A power amplifier (100) includes an input end (RFIN), an output end (RFOUT), a first amplification circuit (PA1), a second amplification circuit (PA3), a bias circuit (BIAS3), a current detection circuit (110), and a first protection circuit (120). The first amplification circuit (PA1) includes a first signal input end (IN1) coupled to the input end (RFIN) and a first signal output end (OUT1). The bias circuit (BIAS3) outputs a bias current (IBIAS3) to the second amplification circuit (PA3). The current detection circuit (110) generates a digital control signal (VOCP) according to the bias current (IBIAS3). The first protection circuit (120) selectively reduces the radio frequency signal (RF) input to the first signal input end (IN1) according to the digital control signal (VOCP).

## Description

### Field of the Invention

The disclosure relates to a power amplifier and a circuit protection method.

### Background of the Invention

The power amplifier is applied to many circuit-related technical fields, such as wireless communication technology. A radio frequency transmitting circuit in wireless communication technology is provided with the power amplifier to amplify a wireless signal to be transmitted to a backend transmitting antenna. The power amplifier is an important element in the radio frequency transmitting circuit, but the power consumption of the power amplifier is quite high, and the power amplifier may be easily damaged due to many factors (for example, unstable input voltage and load mismatch, such that a radio frequency signal cannot be transmitted to the transmitting antenna and to bounce back to form a reflected standing wave, etc.). Therefore, how to protect the power amplifier, so that the power amplifier may operate normally and not be damaged is one of the research directions.

### Summary of the Invention

The present invention is set out in the appended set of claims.

### Brief Description of the Drawings

In the following, the invention is further illustrated by way of example, taking reference to the accompanying drawings. Thereof:
FIG. 1 is a circuit block diagram of a power amplifier according to a first embodiment of the disclosure;
FIG. 2 is a circuit schematic diagram of an amplification circuit PA3, a bias circuit BIAS3, and a current detection circuit according to the first embodiment of the disclosure;
FIG. 3A to FIG. 3F are circuit schematic diagrams of an amplification circuit PA1, a bias circuit BIAS 1, and a first protection circuit according to an embodiment of the disclosure;
FIG. 4A to FIG. 4C are circuit schematic diagrams of the amplification circuit PA1, the bias circuit BIAS 1, and the first protection circuit according to an embodiment of the disclosure;
FIG. 5 is a circuit block diagram of a power amplifier according to a second embodiment of the disclosure;
FIG. 6 is a circuit schematic diagram of the amplification circuit PA1, the bias circuit BIAS1, and a second protection circuit according to a first sub-embodiment of the second embodiment of the disclosure;
FIG. 7 is a circuit schematic diagram of the amplification circuit PA1, the bias circuit BIAS1, the second protection circuit, and a third protection circuit according to a second sub-embodiment of the second embodiment of the disclosure;
FIG. 8 is a circuit block diagram of a power amplifier according to a third embodiment of the disclosure;
FIG. 9 is a circuit block diagram of a power amplifier according to a fourth embodiment of the disclosure; and
FIG. 10 is a flowchart of a circuit protection method according to an embodiment of the disclosure.

### Detailed Description

In order to protect a power amplifier from damage due to sudden large current or power, an embodiment of the disclosure adds a current detection circuit in a bias circuit of a final-stage amplification circuit in the power amplifier to determine whether a bias current provided by the bias circuit in the final-stage amplification circuit is too large. Moreover, when the bias current is determined to be greater than a threshold, a control signal (for example, a digital control signal VOCP) may be used to activate one or more protection circuits of a first-stage amplification circuit disposed in the power amplifier, thereby reducing an amplification gain of the first-stage amplification circuit or reducing the bias current of the first-stage amplification circuit to prevent excessive bias current from flowing through the circuit structure in the power amplifier, thereby protecting the power amplifier from damage.

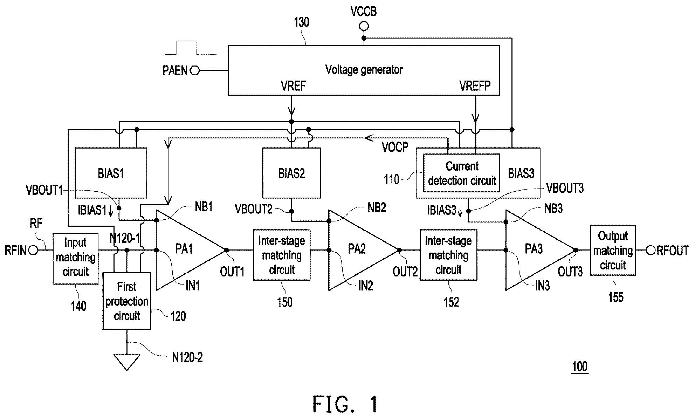

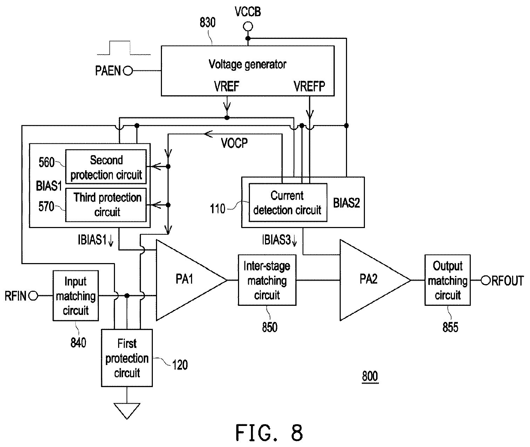

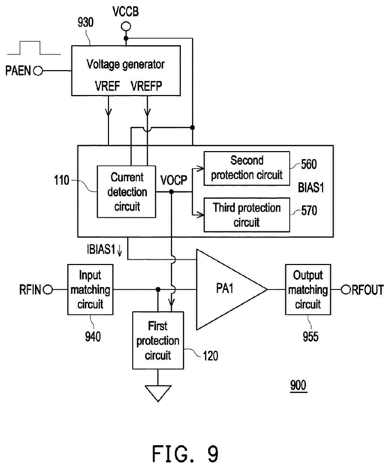

The power amplifier adapted to various applications according to the embodiment of the disclosure may have one or more stages of amplification circuits. For convenience of explanation, a power amplifier 100 of FIG. 1 is based on 3-stage amplification circuits as an example. Other embodiments of the disclosure also be provided with a power amplifier with 2-stage amplification circuits (for example, FIG. 8) and a power amplifier with a 1-stage amplification circuit (for example, FIG. 9). Persons who apply the embodiment may apply the embodiment of the disclosure to power amplifiers with different numbers of amplification circuits according to requirements.

FIG. 1 is a circuit block diagram of the power amplifier 100 according to a first embodiment of the disclosure. The power amplifier 100 mainly includes an input end RFIN, an output end RFOUT, 3-stage amplification circuits (for example, amplification circuits PA1, PA2, and PA3 in FIG. 1), bias circuits BIAS1 to BIAS3 corresponding to each stage of amplification circuit, a current detection circuit 110, and a first protection circuit 120.

The input end RFIN is used to input a radio frequency signal RF. The output end RFOUT is used to output a radio frequency signal amplified by the amplification circuits PA1 to PA3. The amplification circuit PA1 includes a signal input end IN1 coupled to the input end RFIN, a bias end NB1, and a signal output end OUT1. The amplification circuit PA1 is used to amplify the radio frequency signal RF received from the input end RFIN to be provided to the signal output end OUT1.

The amplification circuit PA2 includes a signal input end IN2 coupled to the signal output end OUT1, a bias end NB2, and a signal output end OUT2. The amplification circuit PA2 is used to amplify the radio frequency signal received from the signal input end IN2 to be provided to the signal output end OUT2.

The amplification circuit PA3 includes a signal input end IN3 coupled to the signal output end OUT2 by the amplification circuit PA2. The amplification circuit PA3 also includes a bias end NB3 and a signal output end OUT3. The amplification circuit PA3 is used to amplify the radio frequency signal received from the signal output end OUT2 to be provided to the signal output end OUT3.

The bias circuits BIAS1 to BIAS3 are used to respectively output bias currents IBIAS1 to IBIAS3 to the respective corresponding amplification circuits PA1 to PA3 by respective corresponding output ends VBOUT1 to VBOUT3.

The current detection circuit 110 is coupled to the bias circuit BIAS3 and the amplification circuit PA3. The current detection circuit 110 generates the digital control signal VOCP according to the bias current IBIAS3. The current detection circuit 110 of the embodiment is disposed in the bias circuit BIAS3. Persons who apply the embodiment may dispose the current detection circuit 110 elsewhere according to requirements, as long as the current detection circuit 110 may detect the bias circuit BIAS3.

The first protection circuit 120 is coupled between the input end RFIN of the power amplifier 100 and the signal input end IN1 of the amplification circuit PA1. The first protection circuit 120 selectively reduces the radio frequency signal input to the signal input end IN1 according to the digital control signal VOCP. In other words, the first protection circuit may attenuate an input power of the power amplifier 100 at the input end RFIN based on the digital control signal VOCP. The first protection circuit 120 includes an endpoint N120-1 coupled to the signal input end IN1 and an endpoint N120-2 coupled to a reference voltage end (for example, a ground end).

The power amplifier 100 also includes a voltage generator 130, an input matching circuit 140, inter-stage matching circuits 150 and 152, and an output matching circuit 155. The voltage generator 130 generates reference voltages VREF and VREFP by a first voltage (for example, a system voltage VCCB) according to a power amplifier enable signal PAEN. The bias circuits BIAS1 to BIAS3 generate the respective bias currents IBIAS1 to IBIAS3 based on the reference voltages VREF and VREFP. Each matching circuit (that is, the input matching circuit 140, the inter-stage matching circuit 150, 152, and the output matching circuit 155) has a circuit structure configured based on a stable signal and may be implemented by one of a passive element (for example, one of a resistor, a capacitor, and an inductor or a combination thereof) and an active element (for example, a transistor) or a combination thereof.

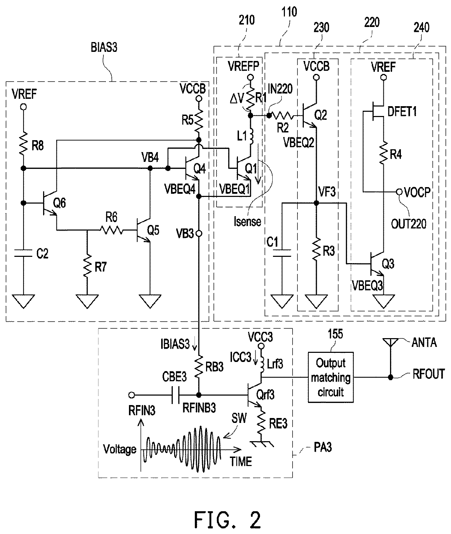

FIG. 2 is a circuit schematic diagram of the amplification circuit PA3, the bias circuit BIAS3, and the current detection circuit 110 according to the first embodiment of the disclosure. FIG. 2 illustrates the detailed circuit structure of the current detection circuit 110. The current detection circuit 110 mainly includes a current detector 210. The current detector 210 is coupled to the bias circuit BIAS3 and the amplification circuit PA3. The output end RFOUT in FIG. 2 is coupled to an antenna ANTA. The antenna ANTA is, for example, a transmitting antenna.

The amplification circuit PA3 mainly includes a transistor Qrf3 and corresponding passive elements (for example, resistors RB3 and RE3, a capacitor CBE3, and an inductor Lrf3). An input end RFIN3 of the amplification circuit PA3 serves as the signal input end IN3 in FIG. 1 to amplify the radio frequency signal received from the signal output end OUT2 to be provided to a signal output end of the amplification circuit PA3. The amplification circuit PA3 receives the bias current IBIAS3 through the resistor RB3.

The bias circuit BIAS3 mainly includes a bias transistor Q4, transistors Q5 and Q6, resistors R5 to R8, and a capacitor C2. The bias transistor Q4 generates the bias current IBIAS3 at an endpoint VB3 by the system voltage VCCB.

The current detector 210 includes a detection transistor Q1. The current detector 210 also includes a resistor R1. The bias transistor Q4 is coupled to the detection transistor Q1 and forms a current mirror architecture. The detection transistor Q1 provides a detection current Isense by the current mirror architecture, and the detection current Isense is related to the bias current IBIAS3. For example, in the embodiment, the size ratio of the bias transistor Q4 to the detection transistor Q1 is equivalent to the ratio of the current value of the current flowing through the resistor R5 (coupled between the bias transistor Q4 and the endpoint providing the system voltage VCCB) and the current value of the detection current Isense, and the sum of the current value of the current flowing through the resistor R5 and the current value of the detection current Isense is the current value of the bias current IBIAS3. When the bias current IBIAS3 increases (for example, due to load mismatch of the power amplifier 100, such that the radio frequency signal cannot be transmitted to the antenna ANTA, causing the radio frequency signal to bounce back to the amplification circuit PA3 to form a reflected standing wave. The reflected standing wave is, for example, a reflected standing wave SW that may occur in the form of voltage on a node RFINB3 in FIG. 2). The voltage value of a base-emitter voltage VBEQ4 in the bias transistor Q4 decreases, and the current value of the current flowing through the resistor R5 increases. Then, the current value of the current flowing through the resistor R5 also reflects the change (increase) to the current value of the detection current Isense according to the size ratio relationship between the bias transistor Q4 and the detection transistor Q1. In other words, when the bias current IBIAS3 increases, the current value of the detection current Isense also increases. The resistor R1 has a voltage drop ΔV based on the detection current Isense.

The current detection circuit 110 further includes a logic circuit 220. The logic circuit 220 includes an input end IN220 and an output end OUT220. The input end IN220 of the logic circuit 220 is coupled to the detection transistor Q1. The logic circuit 220 generates the digital control signal VOCP at the output end OUT220 according to the detection current Isense. In addition, the current detector 210 of the current detection circuit 110 further includes a choke inductor L1. The choke inductor L1 is coupled between the input end IN220 of the logic circuit 220 and the detection transistor Q1 of the current detector 210. The choke inductor L1 may provide a high impedance to prevent the radio frequency signal RF from leaking to the outside (such as leaking to the bias circuit BIAS3), preventing the bias voltage generated by the bias circuit BIAS3 from being affected by the logic circuit 220, thereby stabilizing the function of the amplification circuit PA3.

The logic circuit 220 may include a level conversion circuit 230 and a comparator circuit 240. The level conversion circuit 230 is coupled between the detection transistor Q1 and the comparator circuit 240. The level conversion circuit 230 of the embodiment includes resistors R2 and R3 and a transistor Q2. The level conversion circuit 230 is used to perform level conversion using the detection current Isense to convert the voltage drop ΔV based on the detection current Isense into a voltage at an endpoint VF3. The endpoint VF3 serves as an output end of the level conversion circuit 230. For example, the voltage at the endpoint VF3 may have a voltage value after subtracting the voltage drop ΔV from the reference voltage VREFP, and then subtracting a base-emitter voltage VBEQ2 in the transistor Q2.

The comparator circuit 240 mainly includes a comparison transistor Q3. Furthermore, the state of "the detection current Isense being greater than a threshold" may be used to indicate the state of the bias current IBIAS3 being too large. When the detection current Isense is greater than the threshold, due to the increase in the value of the voltage drop ΔV, the voltage at the output end (the endpoint VF3) of the level conversion circuit 230 decreases, so that the voltage at the output end (the endpoint VF3) of the level conversion circuit 230 becomes less than the voltage value of a base-emitter voltage VBEQ3 in the transistor Q3, causing the comparison transistor Q3 to be in a disconnected state, and the logic circuit 220 enables the digital control signal VOCP based on the disconnected state of the comparison transistor Q3. In other words, the digital control signal VOCP at this time is, for example, at a high potential. Specifically, when the comparison transistor Q3 is in the disconnected state, two ends of a depletion mode transistor DFET1 are conducted to guide the reference voltage VREF to the output end OUT220 of the logic circuit 220, thereby enabling the digital control signal VOCP. In this way, when the bias current IBIAS3 is too large, the output end OUT220 of the logic circuit 220 outputs the enabled digital control signal VOCP. On the contrary, when the detection current Isense is not greater than the threshold, the comparison transistor Q3 is in a conducted state, and the logic circuit 220 disables the digital control signal VOCP based on the conducted state of the comparison transistor Q3. In other words, the digital control signal VOCP at this time is, for example, at a low potential. Therefore, when the bias current IBIAS3 is not too large, the output end OUT220 of the logic circuit 220 outputs the disabled digital control signal VOCP.

The comparator circuit 240 also includes the depletion mode transistor DFET1 and a resistor R4 connected in series. A control end of the comparison transistor Q3 is coupled to the output end (the endpoint VF3) of the level conversion circuit 230. A control end of the depletion mode transistor DFET1 is coupled to the output end OUT220, one end of the depletion mode transistor DFET1 is coupled to the reference voltage VREF, and the other end of the depletion mode transistor DFET1 is coupled to one end of the resistor R4. The other end of the resistor R4 is coupled to the output end OUT220. The depletion mode transistor DFET1 and the resistor R4 are connected in series to form a circuit structure with a large impedance, so that the logic circuit 220 may be more sensitive to the detection of the detection current Isense. For example, a resistance value jointly formed by the depletion mode transistor DFET1 and the resistor R4 is approximately greater than 1 MΩ. To further explain, when the detection current Isense is less than or equal to the threshold, that is, a normal state, which refers to a state where the bias current IBIAS3 is not too large, a voltage between a gate and a source of the depletion mode transistor DFET1 is less than a conduction voltage of the depletion mode transistor DFET1, so that the depletion mode transistor DFET1 remains in the disconnected state. At this time, the resistance value jointly formed by the depletion mode transistor DFET1 and the resistor R4 is equivalent to a resistance between the drain and the source of the depletion mode transistor DFET1 plus the resistance value of the resistor R4. In other words, when the detection current Isense is less than or equal to the threshold, the depletion mode transistor DFET1 and the resistor R4 may jointly form the circuit structure with a large impedance (for example, greater than 1 MΩ), such that the digital control signal VOCP in the detection state may become more obvious, so that the logic circuit 220 may be more sensitive to the detection of the detection current Isense. On the other hand, when the current value of the detection current Isense increases to be greater than the threshold, the voltage between the gate and the source of the depletion mode transistor DFET1 is greater than the conduction voltage of the depletion mode transistor DFET1, so that the depletion mode transistor DFET1 remains in the conducted state. At this time, the resistance value jointly formed by the depletion mode transistor DFET1 and the resistor R4 is equivalent to the resistance value of the resistor R4 alone. In this way, the resistance value jointly formed by the depletion mode transistor DFET1 and the resistor R4 when the detection current Isense is less than or equal to the threshold is greater than the resistance value jointly formed by the depletion mode transistor DFET1 and the resistor R4 when the detection current Isense is greater than the threshold.

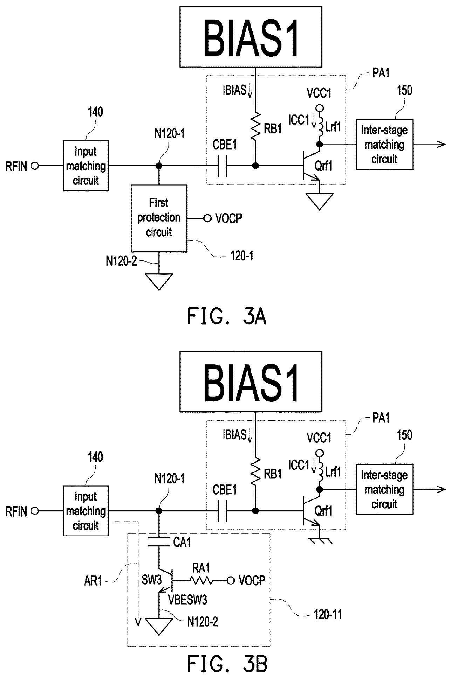

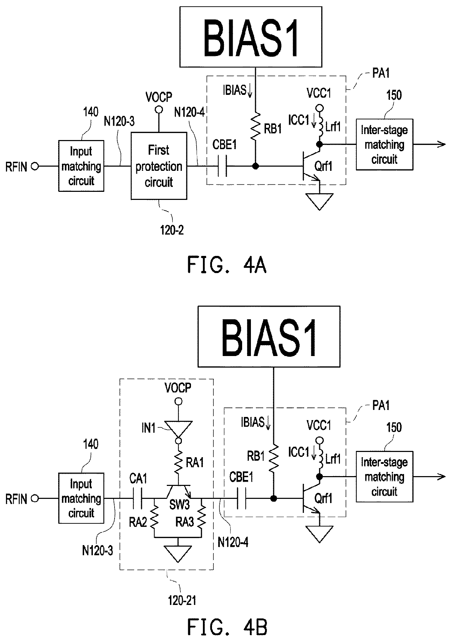

The first protection circuit 120 in FIG. 1 reduces the radio frequency signal input to the signal input end IN1 according to the enabled digital control signal VOCP. FIG. 3A to FIG. 3F and FIG. 4A to FIG. 4C illustrate the function of the first protection circuit 120. FIG. 3A to FIG. 3F are circuit schematic diagrams of the amplification circuit PA1, the bias circuit BIAS1, and first protection circuits 120-1 and 120-11 to 120-15 according to the embodiment of the disclosure. In FIG. 3A to FIG. 3F, one end (the endpoint N120-1) of the first protection circuits 120-1 and 120-11 to 120-15 is coupled to the input matching circuit 140 and an input end of the amplification circuit PA1. The other end (the endpoint N120-2) of the first protection circuits 120-1 and 120-11 to 120-15 in FIG. 3A to FIG. 3F is coupled to the reference voltage end (for example, the ground end).

The amplification circuit PA1 mainly includes a transistor Qrf1 and corresponding passive elements (for example, a resistor RB1, a capacitor CBE1, and an inductor Lrf1). The input end of the amplification circuit PA1 receives the radio frequency signal RF at the input end RFIN by the input matching circuit 140, amplifies the radio frequency signal RF, and provides the radio frequency signal RF to a signal output end of the amplification circuit PA1. The amplification circuit PA1 receives the bias current IBIAS 1 through the resistor RB1.

The endpoint N120-1 of the first protection circuit 120-1 is coupled between the input end RFIN of the power amplifier and the signal input end IN1 of the amplification circuit PA1 (shown in FIG. 1). The endpoint N120-2 of the first protection circuit 1201-1 is coupled to the reference voltage end (for example, the ground end). The first protection circuit 120-1 is used to selectively provide a low-impedance path to the reference voltage end for the radio frequency signal according to the digital control signal VOCP, so that the radio frequency signal at the endpoint N120-1 may be guided to the reference voltage end (for example, the ground end) by the first protection circuit 120 to reduce the transmission of the radio frequency signal to the inside of the structure of the amplification circuit PA1. The first protection circuit 120-1 in FIG. 3A may be implemented as various circuit structures, such as the first protection circuits 120-11 to 120-15 in FIG. 3B to FIG. 3F.

Referring to FIG. 3B, the first protection circuit 120-11 includes a protection transistor SW3, a resistor RA1, and a capacitor CA1. A first end (for example, an emitter end) of the protection transistor SW3 is coupled to the reference voltage end (for example, the ground end). A second end (for example, a collector end) of the protection transistor SW3 is coupled to the endpoint N120-1 of the first protection circuit 120 by the capacitor CA1. A control end (for example, a base end) of the protection transistor SW3 receives the digital control signal VOCP by the resistor RA1. Furthermore, when the bias current IBIAS3 is too large, causing the detection current Isense to be greater than the threshold, the output end OUT220 of the logic circuit 220 outputs the enabled digital control signal VOCP, and the protection transistor SW3 is used to receive the enabled digital control signal VOCP to conduct the first end and the second end of the protection transistor SW3 (as shown by an arrow AR1), so that the radio frequency signal at the endpoint N120-1 is partially guided to the reference voltage end (for example, the ground end). On the contrary, when the bias current IBIAS3 is not too large, causing the detection current Isense to be not greater than the threshold, the output end OUT220 of the logic circuit 220 outputs the disabled digital control signal VOCP, and the protection transistor SW3 is used to receive the disabled digital control signal VOCP to disconnect the first end and the second end of the protection transistor SW3, so that the radio frequency signal at the endpoint N120-1 is not guided to the reference voltage end. In addition, the protection transistor SW3 of the embodiment may, for example, be a bipolar transistor.

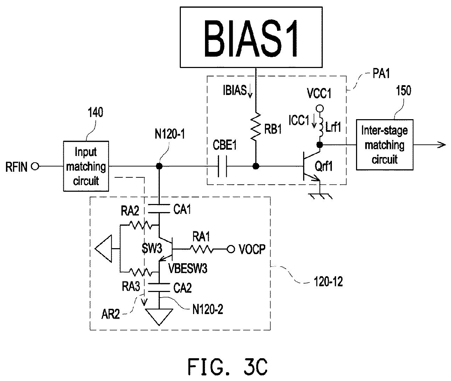

Referring to FIG. 3C, compared with FIG. 3B, the first protection circuit 120-12 also includes resistors RA2 and RA3. One end of the resistor RA2 and one end of the resistor RA3 are coupled to the reference voltage end (for example, the ground end). The other end of the resistor RA2 is coupled to the second end (the collector end) of the protection transistor SW3. The other end of the resistor RA3 is coupled to the first end (the emitter end) of the protection transistor SW3. Therefore, furthermore, when the bias current IBIAS3 is too large, causing the detection current Isense to be greater than the threshold, the output end OUT220 of the logic circuit 220 outputs the enabled digital control signal VOCP, and the protection transistor SW3 is used to receive the enabled digital control signal VOCP to conduct the first end and the second end of the protection transistor SW3 (as shown by an arrow AR2), so that the radio frequency signal at the endpoint N120-1 is partially guided to the reference voltage end (for example, the ground end). On the contrary, when the bias current IBIAS3 is not too large, causing the detection current Isense to be not greater than the threshold, the output end OUT220 of the logic circuit 220 outputs the disabled digital control signal VOCP, and the protection transistor SW3 is used to receive the disabled digital control signal VOCP to disconnect two ends of the protection transistor SW3, so that the radio frequency signal at the endpoint N120-1 is not guided to the reference voltage end. In the embodiment of FIG. 3C, since the two ends of the protection transistor SW3 are respectively coupled to the resistor RA2 and the resistor RA3, when the two ends of the protection transistor SW3 are conducted, a conduction resistance value of the protection transistor SW3 in the embodiment of FIG. 3C is even smaller than the conduction resistance value of the protection transistor SW3 in the embodiment of FIG. 3B, which allows more radio frequency signals to be guided to the reference voltage end, thereby more effectively reducing the transmission of the radio frequency signal to the inside of the structure of the amplification circuit PA1.

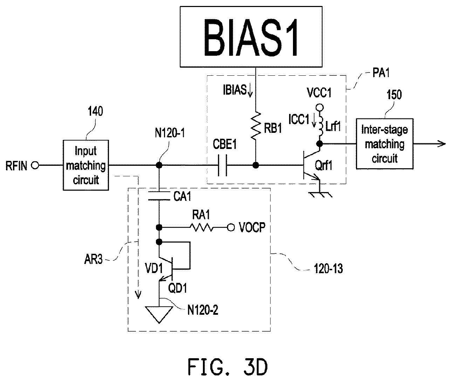

Referring to FIG. 3D, the first protection circuit 120-13 includes a protection transistor QD1, a capacitor C1, and the resistor RA1. A first end (for example, an emitter end) of the protection transistor QD1 is coupled to the reference voltage end (for example, the ground end). A second end (for example, a collector end) and a control end (for example, a base end) of the protection transistor QD1 both receive the digital control signal VOCP by the resistor RA1. The second end (the collector end) and the control end (the base end) of the protection transistor QD1 are coupled to the endpoint N120-1 of the first protection circuit 120 by the capacitor C1. Therefore, furthermore, when the bias current IBIAS3 is too large, causing the detection current Isense to be greater than the threshold, the output end OUT220 of the logic circuit 220 outputs the enabled digital control signal VOCP, and the first end (the emitter end) and the second end (the collector end) of the protection transistor QD1 may be conducted based on the enabled digital control signal VOCP (as shown by an arrow AR3), so that the radio frequency signal at the endpoint N120-1 is partially guided to the reference voltage end (for example, the ground end). On the contrary, when the bias current IBIAS3 is not too large, causing the detection current Isense to be not greater than the threshold, the output end OUT220 of the logic circuit 220 outputs the disabled digital control signal VOCP, and the protection transistor QD1 is used to receive the disabled digital control signal VOCP to disconnect two ends of the protection transistor QD1, so that the radio frequency signal at the endpoint N120-1 is not guided to the reference voltage end. In addition, in the embodiment, the protection transistor QD1 uses, for example, a bipolar transistor as a diode, so the protection transistor QD1 has a simpler architecture.

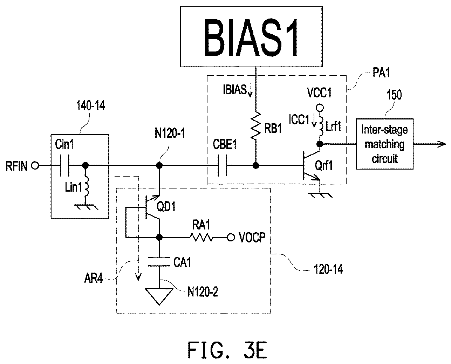

Referring to FIG. 3E, the first protection circuit 120-14 includes the protection transistor QD1, the capacitor C1, and the resistor RA1. A first end (an emitter end) of the protection transistor QD1 is coupled to the endpoint N120-1 of the first protection circuit 120. A second end (a collector end) and a control end (a base end) of the protection transistor QD1 both receive the digital control signal VOCP. The second end (the collector end) and the control end (the base end) of the protection transistor QD1 are coupled to the reference voltage end (for example, the ground end) by the capacitor CA1. Therefore, furthermore, when the bias current IBIAS3 is too large, causing the detection current Isense to be greater than the threshold, the output end OUT220 of the logic circuit 220 outputs the enabled digital control signal VOCP, and the first end (the emitter end) and the second end (the collector end) of the protection transistor QD1 may be conducted based on the enabled digital control signal VOCP (as shown by an arrow AR4), so that the radio frequency signal at the endpoint N120-1 is partially guided to the reference voltage end (for example, the ground end). On the contrary, when the bias current IBIAS3 is not too large, causing the detection current Isense to be not greater than the threshold, the output end OUT220 of the logic circuit 220 outputs the disabled digital control signal VOCP, and the protection transistor QD1 is used to receive the disabled digital control signal VOCP to disconnect two ends of the protection transistor QD1, so that the radio frequency signal at the endpoint N120-1 is not guided to the reference voltage end.

In the embodiment, an input matching circuit 140-14 in FIG. 3E is coupled between the input end RFIN and the first end (the endpoint N120-1) of the first protection circuit 120-14. The input matching circuit 140-14 includes a shunt inductor Lin1 and a capacitor Cin1. One end of the shunt inductor Lin1 is coupled to the reference voltage end (for example, the ground end). The other end of the shunt inductor Lin1 is coupled to the first end (the endpoint N120-1) of the first protection circuit 120 and one end of the capacitor Cin1. The other end of the capacitor Cin1 is coupled to the input end RFIN.

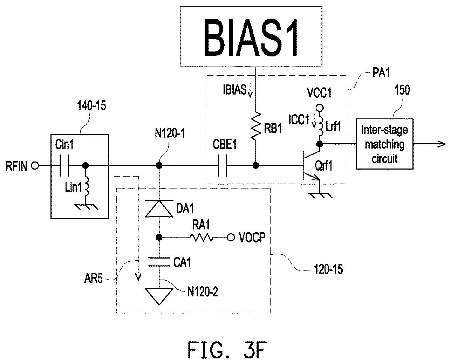

Referring to FIG. 3F, the first protection circuit 120-15 includes a protection diode DA1, the capacitor CA1, and the resistor RA1. An anode end of the protection diode DA1 is coupled to the endpoint N120-1 of the first protection circuit 120. A cathode end of the protection diode DA1 receives the digital control signal VOCP. The cathode end of the protection diode DA1 is coupled to the reference voltage end (for example, the ground end) by the capacitor CA1. Therefore, furthermore, when the bias current IBIAS3 is too large, causing the detection current Isense to be greater than the threshold, the output end OUT220 of the logic circuit 220 outputs the enabled digital control signal VOCP, and the anode end and the cathode end of the protection diode DA1 may be conducted based on the enabled digital control signal VOCP (as shown by an arrow AR5), so that the radio frequency signal at the endpoint N120-1 is partially guided to the reference voltage end (for example, the ground end). On the contrary, when the bias current IBIAS3 is not too large, causing the detection current Isense to be not greater than the threshold, the output end OUT220 of the logic circuit 220 outputs the disabled digital control signal VOCP, and the protection diode DA1 is used to receive the disabled digital control signal VOCP to disconnect two ends of the protection diode DA1, so that the radio frequency signal at the endpoint N120-1 is not guided to the reference voltage end. In the embodiment, an input matching circuit 140-15 in FIG. 3F may have the same circuit structure as the input matching circuit 140-14 in FIG. 3E.

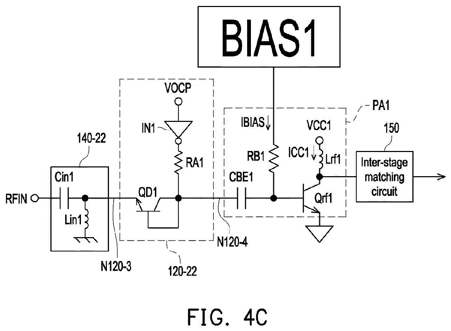

FIG. 4A to FIG. 4C are circuit schematic diagrams of the amplification circuit PA1, the bias circuit BIAS1, and first protection circuits 120-2, 120-21, and 120-22 according to the embodiment of the disclosure. The first end (the endpoint N120-1) of the first protection circuits 120-2, 120-21, and 120-22 in FIG. 4A to FIG. 4C is coupled to the input end RFIN. A second end (an endpoint N120-4) of the first protection circuits 120-2, 120-21, and 120-22 in FIG. 4A to FIG. 4C is coupled to a signal input end of the amplification circuit PA1. The first protection circuit 120-2 is used to selectively provide the high-impedance path for the radio frequency signal according to the digital control signal VOCP to reduce the transmission of the radio frequency signal to the inside of the structure of the amplification circuit PA1. The first protection circuit 120-2 of FIG. 4A may be implemented as various circuit structures, such as the first protection circuits 120-21 and 120-22 of FIG. 4B and FIG. 4C.

Referring to FIG. 4B, the first protection circuit 120-21 includes the protection transistor SW3, the resistors RA2 and RA3, and an inverter IN1. The first end (for example, the emitter end) of the protection transistor SW3 is coupled to the endpoint N120-4 of the first protection circuit 120-21. The second end (for example, the collector end) of the protection transistor SW3 is coupled to the input end RFIN. One end of the resistors RA2 and RA3 is coupled to the reference voltage end (for example, the ground end). The other end of the resistor RA3 is coupled to the first end (the emitter end) of the protection transistor SW3. The other end of resistor RA2 is coupled to the second end (collector end) of the protection transistor SW3, and the other end of the resistor RA2 is coupled to the input end RFIN by the capacitor CA1. The input end of the inverter IN1 receives the digital control signal VOCP. The output end of the inverter IN1 is coupled to the control end (the base end) of the protection transistor SW3 by the resistor RA1.

Therefore, furthermore, when the bias current IBIAS3 is too large, causing the detection current Isense to be greater than the threshold, the output end OUT220 of the logic circuit 220 outputs the enabled digital control signal VOCP, and the first protection circuit 120-21 is used to receive the enabled digital control signal VOCP by the inverter IN1, and the inverter IN1 is used to convert the enabled digital control signal VOCP into a disabled signal, so that the first end (the emitter end) and the second end (the collector end) of the protection transistor SW3 is disconnected. That is, the protection transistor SW3 is in the disconnected state when the logic circuit 220 outputs the enabled digital control signal VOCP to reduce the transmission of the radio frequency signal to the inside of the structure of the amplification circuit PA1. On the contrary, when the bias current IBIAS3 is not too large, causing the detection current Isense to be not greater than the threshold, the output end OUT220 of the logic circuit 220 outputs the disabled digital control signal VOCP, and the inverter IN1 is used to convert the disabled digital control signal VOCP into an enable signal, so that the first end and the second end of the protection transistor SW3 are conducted, thereby allowing the radio frequency signal to be transmitted more completely to the inside of the structure of the amplification circuit PA1.

Referring to FIG. 4C, the first protection circuit 120-22 includes the protection transistor QD1, the resistor RA1, and the inverter IN1. The first end (the emitter end) of the protection transistor QD1 is coupled to the input end RFIN. The second end (the collector end) and the control end (the base end) of the protection transistor QD1 are both coupled to the signal input end of the amplification circuit PA1. The input end of the inverter IN1 receives the digital control signal VOCP. The output end of the inverter IN1 is coupled to the second end (the collector end) and the control end (the base end) of the protection transistor QD1. In the embodiment, an input matching circuit 140-22 in FIG. 4C may have the same circuit structure as the input matching circuits 140-14 and 140-15 in FIG. 3E and FIG. 3F.

Therefore, furthermore, when the bias current IBIAS3 is too large, causing the detection current Isense to be greater than the threshold, the output end OUT220 of the logic circuit 220 outputs the enabled digital control signal VOCP, the first protection circuit 120-22 is used to receive the enabled digital control signal VOCP by the inverter IN1, and the inverter IN1 is used to convert the enabled digital control signal VOCP into a disabled signal, so that the first end (the emitter end) and the second end (the collector end) of the protection transistor QD1 are disconnected. That is, the protection transistor QD1 is in the disconnected state when the logic circuit 220 outputs the enabled digital control signal VOCP to reduce the transmission of the radio frequency signal to the inside of the structure of the amplification circuit PA1. On the contrary, when the bias current IBIAS3 is not too large, causing the detection current Isense to be not greater than the threshold, the output end OUT220 of the logic circuit 220 outputs the disabled digital control signal VOCP, and the inverter IN1 is used to convert the disabled digital control signal VOCP into an enable signal, so that the first end and the second end of the protection transistor QD1 are conducted, thereby allowing the radio frequency signal to be transmitted more completely to the inside of the structure of the amplification circuit PA1.

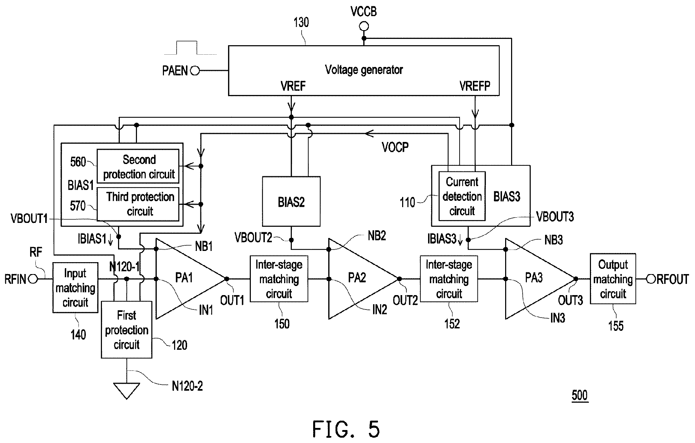

FIG. 5 is a circuit block diagram of a power amplifier 500 according to a second embodiment of the disclosure. The difference between the power amplifier 500 in FIG. 5 and the power amplifier 100 in FIG. 1 is that in addition to the first protection circuit 120, the power amplifier 500 in FIG. 5 also includes a second protection circuit 560 and a third protection circuit 570.

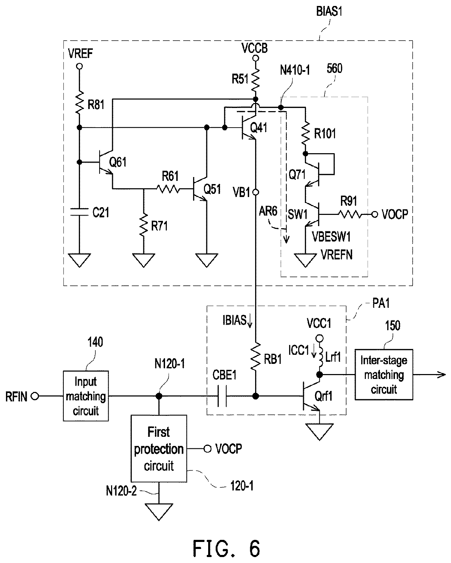

The second protection circuit 560 may reduce the bias current IBIAS 1 and the gain of the amplification circuit PA1 based on the enabled digital control signal VOCP. On the contrary, the bias current IBIAS 1 and the gain of the amplification circuit PA1 may also be maintained (or not reduced) based on the disabled digital control signal VOCP. The third protection circuit 570 further provides a shunt path for the radio frequency signal based on the enabled digital control signal VOCP and the second protection circuit 560, thereby further reducing the bias current IBIAS 1 and the gain of the amplification circuit PA1. On the contrary, the bias current IBIAS 1 and the gain of the amplification circuit PA1 may also be maintained (or not reduced) based on the disabled digital control signal VOCP and the second protection circuit 560. In other words, although the power amplifier 500 in FIG. 5 is provided with the second protection circuit 560 and the third protection circuit 570 at the same time, only the second protection circuit 560 is needed to implement "reducing the bias current IBIAS1 and the gain of the amplification circuit PA1". Please refer to FIG. 6.

FIG. 6 is a circuit schematic diagram of the amplification circuit PA1, the bias circuit BIAS1, and the second protection circuit 560 according to a first sub-embodiment of the second embodiment of the disclosure. The bias circuit BIAS1 mainly includes a bias transistor Q41. The bias circuit BIAS1 also includes transistors Q51 and Q61, resistors R51 to R81, and a capacitor C21. The bias transistor Q41 generates the bias current IBIAS1 at an endpoint VB1 by the system voltage VCCB.

A first end N410-1 of the second protection circuit 560 is coupled to a control end (a base end) of the bias transistor Q41. A second end of the second protection circuit 560 is coupled to the reference voltage end VREFN (for example, the ground end). The second protection circuit 560 mainly includes a protection transistor SW1. The protection transistor SW1 is used to selectively provide a low-impedance path to the reference voltage end (that is, a current path from the first end N410-1 to the reference voltage end VREFN) for the bias current IBIAS1 according to the digital control signal VOCP.

Specifically, the second protection circuit 560 also includes a transistor Q71 and resistors R91 and R101. A base end and a collector end of the transistor Q71 are coupled to each other, and the transistor Q71 is coupled to the first end N410-1 of the second protection circuit 560 by the resistor R91. The control end (the base end) of the protection transistor SW1 receives the digital control signal VOCP by the resistor R91. Therefore, furthermore, when the bias current IBIAS3 is too large, causing the detection current Isense to be greater than the threshold, the output end OUT220 of the logic circuit 220 outputs the enabled digital control signal VOCP, and the two ends (that is, the emitter end and the collector end) of the protection transistor SW1 may be conducted based on the enabled digital control signal VOCP, so that the current at the first end N410-1 of the second protection circuit 560 may flow through the low-impedance path formed by the resistor R101, the transistor Q71, and the protection transistor SW1 to be guided to the reference voltage end VREFN (for example, the ground end) (as shown by an arrow AR6). In this way, not only the voltage at the first end N410-1 of the second protection circuit 560 decreases, but the current value of the bias current IBIAS1 generated by the bias transistor Q41 also decreases. On the contrary, when the bias current IBIAS3 is not too large, causing the detection current Isense to be not greater than the threshold, the output end OUT220 of the logic circuit 220 outputs the disabled digital control signal VOCP, and the two ends of the protection transistor SW1 may be disconnected based on the disabled digital control signal VOCP, so that the current at the first end N410-1 of the second protection circuit 560 is not guided to the reference voltage end VREFN.

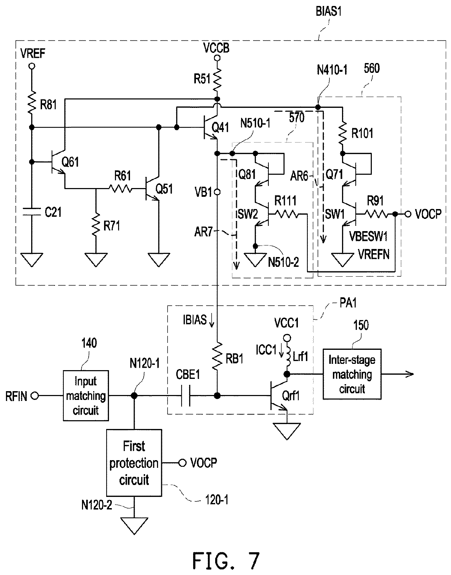

FIG. 7 is a circuit schematic diagram of the amplification circuit PA1, the bias circuit BIAS1, the second protection circuit 560, and the third protection circuit 570 according to a second sub-embodiment of the second embodiment of the disclosure. The architectures of the second protection circuit 560 in FIG. 6 and FIG. 7 are the same. The difference between the second sub-embodiment of FIG. 7 and FIG. 6 is that in addition to the second protection circuit 560, the bias circuit BIAS1 in FIG. 7 also includes the third protection circuit 570.

A first end N510-1 of the third protection circuit 570 is coupled between a first end (an emitter end) of the bias transistor Q41 and a bias output end of the bias circuit BIAS1. A second end N510-2 of the third protection circuit 570 is coupled to the reference voltage end (for example, the ground end). The third protection circuit 570 mainly includes a protection transistor SW2. The protection transistor SW2 is used to selectively provide a low-impedance path to the reference voltage end (that is, a current path from the first end N510-1 to the reference voltage end) for the radio frequency signal based on the digital control signal VOCP.

Specifically, the third protection circuit 570 also includes a transistor Q81 and a resistor R111. A base end and a collector end of the transistor Q81 are coupled to each other, and the transistor Q81 is coupled to the first end N510-1 of the third protection circuit 570. A control end (a base end) of the protection transistor SW2 receives digital control signal VOCP by the resistor R111. Therefore, furthermore, when the bias current IBIAS3 is too large, causing the detection current Isense to be greater than the threshold, the output end OUT220 of the logic circuit 220 outputs the enabled digital control signal VOCP, and two ends (that is, an emitter end and a collector end) of the protection transistor SW2 may be conducted based on the enabled digital control signal VOCP, so that the radio frequency signal at the first end N510-1 of the third protection circuit 570 may flow through a low-impedance path formed by the transistor Q81 and the protection transistor SW2 to be guided to the reference voltage end (for example, the ground end) (as shown by an arrow AR7). In this way, since the radio frequency signal received via the amplification circuit PA1 is partially guided to the reference voltage end via the low-impedance path, the transmission of the radio frequency signal to the amplification circuit PA1 may be reduced, so the third protection circuit 570 may reduce the gain of the amplification circuit PA1. On the contrary, when the bias current IBIAS3 is not too large, causing the detection current Isense to be not greater than the threshold, the output end OUT220 of the logic circuit 220 outputs the disabled digital control signal VOCP, and the two ends of the protection transistor SW2 may be disconnected based on the disabled digital control signal VOCP, so that the radio frequency signal at the first end N510-1 of the third protection circuit 570 is not guided to the reference voltage end.

FIG. 8 is a circuit block diagram of a power amplifier 800 according to a third embodiment of the disclosure. The power amplifier 800 in FIG. 8 is implemented by adopting 2-stage amplification circuits. In detail, the power amplifier 800 mainly includes the input end RFIN, the output end RFOUT, the 2-stage amplification circuits (for example, the amplification circuits PA1 and PA2), bias circuits BIAS1 to BIAS2 corresponding to each stage of the amplification circuit, the current detection circuit 110, and the first protection circuit 120. The power amplifier 800 also includes a voltage generator 830, an input matching circuit 840, an inter-stage matching circuit 850, and an output matching circuit 855. The power amplifier 800 may also include the second protection circuit 560 and the third protection circuit 570.

In other words, the current detection circuit 110 in FIG. 1 may be applied to the bias circuit BIAS2 in the power amplifier 800 in FIG. 8 and generates the digital control signal VOCP according to a bias current IBIAS2 of the final-stage amplification circuit (for example, the amplification circuit PA2). The first protection circuit 120, the second protection circuit 560, and the third protection circuit 570 are disposed at the first-stage amplification circuit (for example, the amplification circuit PA1). When the bias current IBIAS2 is determined to be greater than the threshold, the digital control signal VOCP may be used to activate one of the first protection circuit 120, the second protection circuit 560, and the third protection circuit 570 or a combination thereof of the first-stage amplification circuit in the power amplifier 800, thereby reducing the amplification gain of the amplification circuit PA1 or reducing the bias current of the amplification circuit PA1 to prevent excessive bias current from flowing through the circuit structure in the power amplifier 800 and damaging the circuit structure in the power amplifier 800. Please refer to the foregoing embodiments for the circuit structures and the corresponding element structures of the first protection circuit 120, the second protection circuit 560, and the third protection circuit 570.

FIG. 9 is a circuit block diagram of a power amplifier 900 according to a fourth embodiment of the disclosure. The power amplifier 900 in FIG. 9 is implemented by adopting a one-stage amplification circuit (that is, the amplification circuit PA1). Specifically, the power amplifier 900 mainly includes the input end RFIN, the output end RFOUT, the amplification circuit PA1, the bias circuit BIAS1, the current detection circuit 110, and the first protection circuit 120. The power amplifier 900 also includes a voltage generator 930, an input matching circuit 940, and an output matching circuit 955.

In other words, the current detection circuit 110 in FIG. 1 may be applied to the bias circuit BIAS1 in FIG. 9 and generates the digital control signal VOCP according to the bias current IBIAS1 of the final-stage amplification circuit (the amplification circuit PA1). The first protection circuit 120, the second protection circuit 560, and the third protection circuit 570 are disposed at the first-stage amplification circuit (the amplification circuit PA1). When the bias current IBIAS1 is determined to be greater than the threshold, the digital control signal VOCP may be used to activate one of the first protection circuit 120, the second protection circuit 560, and the third protection circuit 570 or a combination thereof disposed in the power amplifier 900, thereby reducing the amplification gain of the amplification circuit PA1 or reducing the bias current of the amplification circuit PA1 to prevent excessive bias current from flowing through the circuit structure in the power amplifier 900 and damaging the circuit structure in the power amplifier 900. When the bias current IBIAS 1 is determined to be not greater than the threshold, the first protection circuit 120, the second protection circuit 560, and the third protection circuit 570 disposed in the power amplifier 900 may be turned off by the digital control signal VOCP. Please refer to the foregoing embodiments for the circuit structures and the corresponding element structures of the first protection circuit 120, the second protection circuit 560, and the third protection circuit 570.

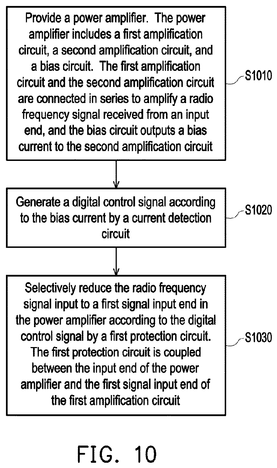

FIG. 10 is a flowchart of a circuit protection method according to an embodiment of the disclosure. The circuit protection method of FIG. 10 may be applied to each of the power amplifiers 100, 800, and 900 of FIG. 1 to FIG. 9. Here, the power amplifier 100 in FIG. 1 is taken as an example for illustration of each step of the circuit protection method in FIG. 10.

In step S1010, the power amplifier 100 in FIG. 1 is provided. The power amplifier 100 at least includes the amplification circuit PA1, the amplification circuit PA3, and the bias circuit BIAS3. The amplification circuit PA1 and the amplification circuit PA3 are connected in series to amplify the radio frequency signal RF received from the input end RFIN, and the bias circuit BIAS3 outputs the bias current IBIAS3 to the amplification circuit PA3.

In step S1020, the digital control signal VOCP is generated according to the bias current IBIAS3 by the current detection circuit 110. Specifically, the current mirror architecture is formed by the bias transistor Q4 and the detection transistor Q1 in FIG. 2 to provide the detection current Isense, and the detection current Isense is related to the bias current IBIAS3. Whether the detection current Isense is greater than the threshold is determined. When the detection current Isense is greater than the threshold, the digital control signal VOCP is enabled. In addition, when the detection current Isense is not greater than the threshold, the digital control signal VOCP is disabled.

In step S1030, the radio frequency signal input to the signal input end IN1 in the power amplifier 100 is selectively reduced according to the digital control signal VOCP by the first protection circuit 120. The first protection circuit 120 may implement step S1030. The first protection circuit 120 is coupled between the input end RFIN of the power amplifier 100 and the signal input end IN1 of the amplification circuit PA1. For example, the first protection circuit 120 selectively provides a first low-impedance path to the reference voltage end in the first protection circuit 120 for the radio frequency signal from the signal input end IN1 in the power amplifier 100 according to the digital control signal VOCP.

On the other hand, the second protection circuit 560 may be provided to implement step S1030. The second protection circuit 560 selectively provides a second low-impedance path to the reference voltage end for the bias current IBIAS1 according to the digital control signal VOCP. Further, the third protection circuit 570 may be provided to implement step S1030. The third protection circuit 570 selectively provides a third low-impedance path to the reference voltage end for the radio frequency signal according to the digital control signal VOCP. Please refer to the foregoing embodiments for details of each of steps S1010 to S1030.

In summary, the power amplifier and the circuit protection method of the embodiments of the disclosure add the current detection circuit in the bias circuit of the final-stage amplification circuit in the power amplifier to determine whether the bias current provided by the bias circuit in the final-stage amplification circuit is too large. Moreover, when the bias current is determined to be greater than the threshold, the control signal (for example, the digital control signal VOCP) may be used to activate one or more protection circuits of the first-stage amplification circuit disposed in the power amplifier, thereby reducing the amplification gain of the first-stage amplification circuit or reducing the bias current of the first-stage amplification circuit to prevent excessive bias current from flowing through the circuit structure in the power amplifier, thereby protecting the power amplifier from damage.

## Claims

1. A power amplifier (100, 800), **characterised by** comprising:
an input end (RFIN), used to input a radio frequency signal (RF);
an output end (RFOUT), used to output the amplified radio frequency signal;
a first amplification circuit (PA1), comprising a first signal input end (IN1) coupled to the input end (RFIN) and a first signal output end (OUT1) and used to amplify the radio frequency signal (RF) received from the input end (RFIN);
a second amplification circuit (PA3), comprising a second signal input end (IN3) coupled to the first signal output end (OUT1) and a second signal output end (OUT3) and used to amplify the radio frequency signal received from the first signal output end (OUT1);
a bias circuit (BIAS3), used to output a bias current (IBIAS3) to the second amplification circuit (PA3);
a current detection circuit (110), coupled to the bias circuit (BIAS3) and the second amplification circuit (PA3) and used to generate a digital control signal (VOCP) according to the bias current (IBIAS3); and
a first protection circuit (120), coupled between the input end (RFIN) of the power amplifier (100) and the first signal input end (IN1) of the first amplification circuit (PA1), wherein the first protection circuit (120) selectively reduces the radio frequency signal (RF) input to the first signal input end (IN1) according to the digital control signal (VOCP).

2. The power amplifier (100, 800) according to claim 1, **characterised in that** the current detection circuit (110) comprises a current detector (210), and the current detector (210) is coupled to the bias circuit (BIAS3) and the second amplification circuit (PA3),
wherein the current detector (210) comprises a detection transistor (Q1),
wherein the bias circuit (BIAS3) comprises a bias transistor (Q4),
wherein the bias transistor (Q4) is coupled to the detection transistor (Q1) and forms a current mirror architecture, the detection transistor (Q1) provides a detection current (Isense) by the current mirror architecture, and the detection current (Isense) is related to the bias current (IBIAS3).

3. The power amplifier (100, 800) according to claim 2, **characterised in that** the current detection circuit (110) further comprises:
a logic circuit (220), comprising an input end (IN220), an output end (OUT220) and a comparison transistor (Q3),
wherein the input end (IN220) of the logic circuit (220) is coupled to the detection transistor (Q1), and the logic circuit (220) generates the digital control signal (VOCP) at the output end (OUT220) according to the detection current (Isense);
wherein when the detection current (Isense) is greater than a threshold, the comparison transistor (Q3) is in a disconnected state, and the logic circuit (220) enables the digital control signal (VOCP) based on the disconnected state of the comparison transistor (Q3); and
wherein the first protection circuit (120) reduces the radio frequency signal (RF) input to the first signal input end (IN1) according to the enabled digital control signal (VOCP).

4. The power amplifier (100, 800) according to claim 2, **characterised in that** the current detection circuit (110) further comprises:
a logic circuit (220), comprising an input end (IN220) and an output end (OUT220),
wherein the input end (IN220) of the logic circuit (220) is coupled to the detection transistor (Q1), and the logic circuit (220) generates the digital control signal (VOCP) at the output end (OUT220) according to the detection current (Isense); and
wherein the current detector further comprises a choke inductor (L1), and the choke inductor (L1) is coupled between the input end (IN220) of the logic circuit (220) and the detection transistor (Q1).

5. The power amplifier (100, 800) according to claim 1, **characterised in that** the first protection circuit (120) comprises a first end (N120-1) and a second end (N120-2), the first end (N120-1) is coupled between the input end (RFIN) of the power amplifier (100) and the first signal input end (IN1) of the first amplification circuit (PA1), the second end (N120-2) is coupled to a reference voltage end, and the first protection circuit (120) is used to selectively provide a low-impedance path for the radio frequency signal (RF) according to the digital control signal (VOCP).

6. The power amplifier (100, 800) according to claim 5, **characterised in that** the first protection circuit (120) comprises:
a first protection transistor (SW3), wherein a first end of the first protection transistor (SW3) is coupled to the reference voltage end, a second end of the first protection transistor (SW3) is coupled to the first end (N120-1) of the first protection circuit (120), and the first protection transistor (SW3) is used to receive the enabled digital control signal (VOCP) to conduct the first end and the second end of the first protection transistor (SW3).

7. The power amplifier (100, 800) according to claim 6, **characterised in that** the first protection circuit (120) further comprises:
a first resistor (RA2) and a second resistor (RA3),
wherein a first end of the first resistor (RA2) and a first end of the second resistor (RA3) are coupled to the reference voltage end, a second end of the first resistor (RA2) is coupled to the second end of the first protection transistor (SW3), and a second end of the second resistor (RA3) is coupled to the first end of the first protection transistor (SW3).

8. The power amplifier (100, 800) according to claim 5, **characterised in that**:
the first protection circuit (120) comprises:
a first protection transistor (QD1), wherein a first end of the first protection transistor (QD1) is coupled to the reference voltage end, and a second end and a control end of the first protection transistor (QD1) both receive the digital control signal (VOCP); and
a first capacitor (C1), wherein the second end and the control end of the first protection transistor (QD1) are coupled to the first end (N120-1) of the first protection circuit (120) by the first capacitor (C1),
wherein the first end and the second end of the first protection transistor (QD1) are conducted based on the enabled digital control signal (VOCP), or
the first protection circuit (120) comprises:
a first protection transistor (QD1), wherein a first end of the first protection transistor (QD1) is coupled to the first end (N120-1) of the first protection circuit (120), and a second end and a control end of the first protection transistor (QD1) both receive the digital control signal (VOCP); and
a first capacitor (CA1), wherein the second end and the control end of the first protection transistor (QD1) are coupled to the reference voltage end by the first capacitor (CA1),
wherein the first end and the second end of the first protection transistor (QD1) are conducted based on the enabled digital control signal (VOCP); or
the first protection circuit (120) comprises:
a first protection diode (DA1), wherein an anode end of the first protection diode (DA1) is coupled to the first end (N120-1) of the first protection circuit (120), and a cathode end of the first protection diode (DA1) receives the digital control signal (VOCP); and
a first capacitor (CA1), wherein the cathode end of the first protection diode (DA1) is coupled to the reference voltage end by the first capacitor (CA1),
wherein the anode end and the cathode end of the first protection diode (DA1) are conducted based on the enabled digital control signal (VOCP).

9. The power amplifier (100, 800) according to claim 1, **characterised in that** the first protection circuit (120) comprises a first end (N120-1) and a second end (N120-4), the first end (N120-1) is coupled to the input end (RFIN) of the power amplifier (100), the second end (N120-4) is coupled to the first signal input end (IN1) of the first amplification circuit (PA1), and the first protection circuit (120) is used to selectively provide a high-impedance path for the radio frequency signal (RF) according to the digital control signal (VOCP).

10. The power amplifier (100, 800) according to claim 9, **characterised in that**:
the first protection circuit (120) comprises:
a first protection transistor (SW3), wherein a first end of the first protection transistor (SW3) is coupled to the second end (N120-4) of the first protection circuit (120), and a second end of the first protection transistor (SW3) is coupled to the input end (RFIN);
a first resistor (RA3), wherein a first end of the first resistor (RA3) is coupled to a reference voltage end, and a second end of the first resistor (RA3) is coupled to the first end of the first protection transistor (SW3);
a second resistor (RA2), wherein a first end of the second resistor (RA2) is coupled to the reference voltage end, and a second end of the second resistor (RA2) is coupled to the input end (RFIN); and
an inverter (IN1), wherein an input end of the inverter (IN1) receives the digital control signal (VOCP), and an output end of the inverter (IN1) is coupled to a control end of the first protection transistor (SW3),
wherein the first protection circuit (120) is used to receive the enabled digital control signal (VOCP) by the inverter (IN1) to disconnect the first end and the second end of the first protection transistor (SW3); or
the first protection circuit (120) comprises:
a first protection transistor (QD1), wherein a first end of the first protection transistor (QD1) is coupled to the input end (RFIN), and a second end and a control end of the first protection transistor (QD1) are both coupled to the first signal input end (IN1) of the first amplification circuit (PA1); and
an inverter (IN1), wherein an input end of the inverter (IN1) receives the digital control signal (VOCP), and an output end of the inverter (IN1) is coupled to the second end and the control end of the first protection transistor (QD1),
wherein the first protection circuit (120) is used to receive the enabled digital control signal (VOCP) by the inverter (IN1) to disconnect the first end and the second end of the first protection transistor (QD1).

11. The power amplifier (100, 800) according to claim 1, **characterised in that** the bias circuit (BIAS3) is a second bias circuit used to output a second bias current (IBIAS3),
wherein the power amplifier (100) further comprises:
a first bias circuit (BIAS1), used to output a first bias current (IBIAS1) to the first amplification circuit (PA1),
wherein the first bias circuit (BIAS1) comprises a first bias transistor (Q41),
wherein the power amplifier (100) further comprises:
a second protection circuit (560), wherein a first end (N410-1) of the second protection circuit (560) is coupled to a control end of the first bias transistor (Q41), and a second end of the second protection circuit (560) is coupled to a reference voltage end (VREFN),
wherein the second protection circuit (560) comprises a second protection transistor (SW1), and the second protection transistor (SW1) is used to selectively provide a low-impedance path to the first bias current (IBIAS1) according to the digital control signal (VOCP).

12. The power amplifier (100, 800) according to claim 11, **characterised by** further comprising:
a third protection circuit (570), wherein a first end (N510-1) of the third protection circuit (570) is coupled between a first end of the first bias transistor (Q41) and a first bias output end of the first bias circuit (BIAS1), and a second end (N510-2) of the third protection circuit (570) is coupled to the reference voltage end,
wherein the third protection circuit (570) comprises a third protection transistor (SW2), and the third protection transistor (SW2) is used to selectively provide a low-impedance path for the radio frequency signal (RF) according to the digital control signal (VOCP).

13. The power amplifier (100) according to claim 1, **characterised by** further comprising:
a third amplification circuit (PA2), coupled between the first amplification circuit (PA1) and the second amplification circuit (PA3) and used to amplify the radio frequency signal (RF); and
a third bias circuit (BIAS2), used to output a third bias current (IBIAS2) to the third amplification circuit (PA2),
wherein the third amplification circuit (PA2) comprises:
a third signal input end (IN2), coupled to the first signal output end (OUT1) of the first amplification circuit (PA1); and
a third signal output end (OUT2), coupled to the first signal input end (IN3) of the second amplification circuit (PA3).

14. A circuit protection method, **characterised by** comprising:
providing a power amplifier (100), wherein the power amplifier (100) comprises a first amplification circuit (PA1), a second amplification circuit (PA3), and a bias circuit (BIAS3), wherein the first amplification circuit (PA1) and the second amplification circuit (PA3) are connected in series to amplify a radio frequency signal (RF) received from an input end (RFIN), and the bias circuit (BIAS3) outputs a bias current (IBIAS3) to the second amplification circuit (PA3);
generating a digital control signal (VOCP) according to the bias current (IBIAS3) by a current detection circuit (110); and
selectively reducing the radio frequency signal (RF) input to a first signal input end (IN1) in the power amplifier (100) according to the digital control signal (VOCP) by the first protection circuit (120), wherein the first protection circuit (120) is coupled between the input end (RFIN) of the power amplifier (100) and the first signal input end (IN1) of the first amplification circuit (PA1).

15. A power amplifier (900), **characterised by** comprising:
an input end (RFIN), used to input a radio frequency signal;
an output end (RFOUT), used to output the amplified radio frequency signal;
an amplification circuit (PA1), comprising a first signal input end coupled to the input end (RFIN) and a first signal output end and used to amplify the radio frequency signal received from the input end (RFIN);
a bias circuit (BIAS 1), used to output a bias current (IBIAS 1) to the amplification circuit (PA1);
a current detection circuit (110), used to generate a digital control signal (VOCP) according to the bias current (IBIAS1); and
a first protection circuit (120), coupled to the current detection circuit (110) and coupled to a node between the input end (RFIN) of the power amplifier (900) and the first signal input end of the amplification circuit (PA1) and used to selectively reduce the radio frequency signal input to the first signal input end according to the digital control signal (VOCP).
